# EUROPEAN PATENT APPLICATION

(11) **EP 4 273 304 A1**
(43) Date of publication of application: **08.11.2023**
(21) Application number: 21915577.7
(22) Date of filing: 06.12.2021
(51) Int. Cl.: C25D 5/00, C25D 1/04, H05K 3/38, H05K 1/09

(54) **SURFACE-TREATED COPPER FOIL AND CIRCUIT BOARD COMPRISING SAME**

(30) Priority: 30.12.2020 KR 20200187233
(71) Applicant: SKC Co., Ltd., Suwon-si, Gyeonggi-do 16336 (KR)
(72) Inventor: YOO, Il Hwan, Suwon-si, Gyeonggi-do 16338 (KR); JUNG, Joo Young, Suwon-si, Gyeonggi-do 16338 (KR); KYUN, Myung Ok, Suwon-si, Gyeonggi-do 16338 (KR); RYU, Ji Yeon, Suwon-si, Gyeonggi-do 16338 (KR); OH, Seung Bae, Suwon-si, Gyeonggi-do 16338 (KR)
(74) Representative: Stolmár & Partner Patentanwälte PartG mbB
(86) International application number: PCT/KR2021/018342
(87) International publication number: WO 2022/145779

(57) **Abstract**

A surface-treated copper foil according to exemplary embodiments includes a copper foil layer and a protrusion layer formed on one surface of the copper foil layer. Pores are formed inside the protrusion layer or around a boundary between the copper foil layer and the protrusion layer. Abnormal growth of the protrusions may be prevented through the pores and thus a bonding force with the insulation layer may be improved.

## Description

### [BACKGROUND ART]

Embodiments of the present application relate to a surface-treated copper foil and a circuit board including the same, and more specifically, to a surface-treated copper foil which includes a roughened surface and a circuit board including the surface-treated copper foil.

### [BACKGROUND ART]

For example, in order to manufacture a printed circuit board, a copper clad laminate (CCL) is used, and the copper clad laminate includes a copper layer in the form of a copper foil for forming a circuit.

The copper foil may be subjected to roughening treatment in order to secure stable bonding force and adhesive force on a surface thereof, which is in contact with a resin layer. Accordingly, the surface of the copper foil may have a relatively high roughness and may include protrusions.

For example, after a plating process for forming a copper thin film, another plating process for forming the protrusions may be performed by changing the process conditions. Due to the protrusions, a peeling strength of the copper foil may be increased. However, when the protrusions are excessively grown or formed irregularly, the peeling strength may be rather decreased, and high frequency transmission characteristics of the printed circuit board may be deteriorated.

Therefore, development of a surface-treated copper foil capable of forming a circuit with a fine pattern while increasing a peeling force of the copper foil is required.

### DETAILED DECRIPTIONS OF THE INVENTION

### [Technical Objective]

According to an aspect of exemplary embodiments, there is provided a surface-treated copper foil having improved mechanical and electrical stabilities.

According to an aspect of exemplary embodiments, there is provided a circuit board including the surface-treated copper foil having improved mechanical and electrical stabilities.

### [Technical Means]

A surface-treated copper foil according to exemplary embodiments includes a copper foil layer and a protrusion layer formed on one surface of the copper foil layer. The surface-treated copper foil includes pores formed inside the protrusion layer or around a boundary between the copper foil layer and the protrusion layer.

In some embodiments, the pores may include first pores arranged along a boundary line between the copper foil layer and the protrusion layer.

In some embodiments, the first pores may have an average diameter of 0.01 to 0.05 µm.

In some embodiments, an average interval between the adjacent first pores may be 0.15 to 0.25 µm.

In some embodiments, the first pores may be distributed in a height region within 1/3 from the lowest point of the protrusion layer based on a sum of thicknesses of the copper foil layer and the protrusion layer.

In some embodiments, the pores may further include second pores formed inside the protrusion layer.

In some embodiments, the number of the second pores may be smaller than the number of the first pores.

In some embodiments, the protrusion layer may include a plurality of protrusions, and a ratio of a cross-sectional area of the second pores to a cross-sectional area of one of the protrusions may be 0.001 to 20%.

In some embodiments, the protrusion layer may include a plurality of protrusions, and a ratio of a cross-sectional area of the second pores to a cross-sectional area of one of the protrusions may be 0.001 to 5%.

A circuit board according to exemplary embodiments includes an insulation layer, and a wiring layer which is formed on a surface of the insulation layer and includes a copper foil layer and a protrusion layer formed on one surface of the copper foil layer. The wiring layer includes pores formed inside the protrusion layer or around a boundary between the copper foil layer and the protrusion layer.

### [Effects of the Invention]

According to the above-described embodiments, a protrusion layer may be formed on one surface of a copper foil layer, and pores arranged in a line shape around a boundary between the copper foil layer and the protrusion layer may be formed. Through the pores, the growth of the protrusions is adjusted, such that a uniform bonding force with the insulation layer may be secured.

The pores may be formed with a predetermined diameter/interval to provide sufficient bonding force and peeling strength while suppressing an increase in the resistance of the copper foil layer.

### [Brief Descriptions of the Drawings]

FIGS. 1 and. 2 are schematic cross-sectional views illustrating a surface-treated copper foil according to exemplary embodiments, respectively.
FIG. 3 is a schematic cross-sectional view illustrating a circuit board according to exemplary embodiments.

### [Embodiments for Practicing the Invention]

Hereinafter, embodiments of the present application will be described in detail. In this regard, the present invention may be altered in various ways and have various embodiments, such that specific embodiments will be illustrated in the drawings and described in detail in the present disclosure. However, the present invention is not limited to the specific embodiments, and it will be understood by those skilled in the art that the present invention is to cover all modifications, equivalents, and alternatives falling within the spirit and scope of the present invention.

Unless otherwise defined, all terms including technical and scientific terms used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

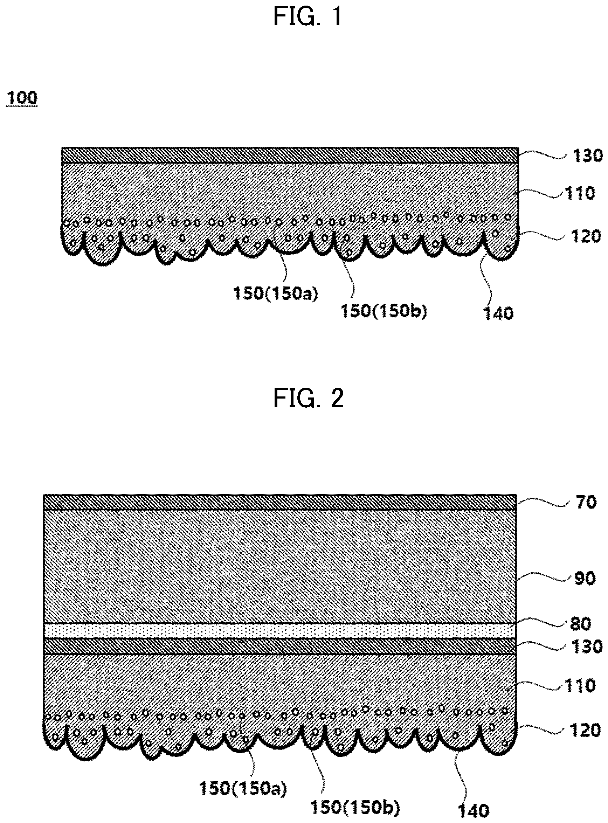

FIGS. 1 and. 2 are schematic cross-sectional views illustrating a surface-treated copper foil according to exemplary embodiments, respectively.

Referring to FIG. 1, a surface-treated copper foil 100 according to exemplary embodiments may include a copper foil layer 110, and a protrusion layer 120 formed on one surface of the copper foil layer 110.

The copper foil layer 110 may be formed through an electrolytic copper plating process, for example. The copper foil layer 110 may have a thickness of about 1 to 10 µm. The copper foil layer 110 may be converted into a circuit wiring having a predetermined line width included in a circuit board through etching/patterning processes, for example.

The protrusion layer 120 may be formed on a lower or inner surface of the copper foil layer 110. The protrusion layer 120 may be provided as a roughened layer of the copper foil layer 110.

The protrusion layer 120 may be formed by electrodepositing copper on the lower or inner surface of the copper foil layer 110. According to exemplary embodiments, preliminary electrolytic plating for forming protrusion growth nuclei may be performed on the lower surface or inner surface of the copper foil layer 110, and then plating for forming the protrusions (e.g., capsule plating) may be performed to form the protrusion layer 120.

A concentration of a copper salt used in the preliminary electrolytic plating for forming the protrusion growth nuclei may be lower than a concentration of the copper salt used in the plating for forming the protrusions.

In some embodiments, in order to form a substantially roughened surface through the protrusion layer 120, plating for forming the protrusions may be performed at a lower current density than that of the electroplating for forming the copper foil layer 110.

As described above, when the protrusion layer 120 is formed through the plating process, the protrusion layer 120 and the copper foil layer 110 may be substantially connected or integrally formed with each other.

As the protrusion layer 120 is provided, a bonding force between the surface of a core layer or insulation layer of the circuit board, such as an epoxy resin or polyimide resin, and the copper foil layer 110 may be enhanced.

As shown in FIG. 1, the protrusion layer 120 may include a plurality of protrusions which are distributed with substantially random heights or widths. As the protrusions have a random distribution, a roughness of the copper foil layer 110 is increased, such that the bonding force with the core layer or the insulation layer may be further increased.

The protrusion layer 120 or the protrusions included therein may have a thickness of about 0.5 to 1.5 µm. The thickness of the protrusion layer 120 may be smaller than that of the copper foil layer 110.

The surface-treated copper foil 100 according to exemplary embodiments may include pores 150 formed inside the copper foil layer 110 and/or the protrusion layer 120.

According to exemplary embodiments, the pores 150 may be formed around a boundary between the copper foil layer 110 and the protrusion layer 120. The pores 150 may also be formed inside the protrusions included in the protrusion layer 120.

In some embodiments, the pores 150 may include first pores 150a and second pores 150b. The first pores 150a may be formed along the boundary between the copper foil layer 110 and the protrusion layer 120. The second pores 150b may be formed in the protrusions.

As described above, the first pores 150a may be arranged substantially along the boundary line between the copper foil layer 110 and the protrusion layer 120. The first pores 150a may serve as a barrier for suppressing excessive and abnormal growth of the protrusions.

For example, formation of tips or spikes due to the abnormal growth of local protrusions from the lower surface of the copper foil layer 110 may be suppressed by the first pores 150a arranged in a line shape. Therefore, deterioration of insulation resistance characteristics due to tearing of the insulation layer caused by the abnormal growth protrusions may be prevented.

In addition, when the pores 150 are arranged as described above, overall random characteristics may be imparted while suppressing excessive and abnormal growth of the protrusions. Therefore, improvement of the bonding force/peeling strength through the protrusion layer 120 may be effectively implemented.

In one embodiment, the first pores 150a may have an average diameter of about 0.01 to 0.05 µm. In one embodiment, an average interval between the adjacent first pores 150a may be about 0.15 to 0.25 µm.

Within the above diameter and/or interval range, it is possible to sufficiently suppress the abnormal growth of the protrusions through the first pores 150a, while sufficiently increasing the bonding force/peeling force through the protrusions.

In some embodiments, the first pores 150a may be distributed in a height region within 1/3 from the lowest point of the protrusion layer based on a sum of thicknesses of the copper foil layer 110 and the protrusion layer 120. Accordingly, an increase in the resistance at a portion of the copper foil layer 110 substantially provided as a current passage of the wiring layer may be prevented by the first pores 150a.

As described above, the second pores 150b may be formed in each protrusion. The number of the second pores 150b may be smaller than the number of the first pores 150a. In one embodiment, the number of the second pores 150b may be smaller than the number of the first pores 150a throughout the surface-treated copper foil 100. In one embodiment, the number of the second pores 150b within a width corresponding to one protrusion may be smaller than the number of the first pores 150a.

An adhesive force to the insulation layer of the protrusion layer 120 may also be enhanced by the second pores 150b. For example, randomness of the protrusion growth may be increased by the second pores 150b. Accordingly, the bonding force/peeling force of the surface-treated copper foil 100 due to the protrusion layer 120 may be further improved.

In one embodiment, a ratio of a cross-sectional area of the second pore 150b to a cross-sectional area of one of the protrusions may be about 0.001 to 20%, preferably 0.001 to 10%, and more preferably 0.001 to 5%. Within the above range, an increase in the bonding force may be sufficiently implemented while preventing an excessive increase in the resistance in the protrusion layer 120.

A protrusion coating layer 140 may be formed on the surface of the protrusion layer 120. The protrusion coating layer 140 may be formed through anticorrosive treatment using, for example, nickel (Ni), zinc (Zn) and/or chromium (Cr).

In one embodiment, nickel plating and zinc plating processes may be performed on the surface of the protrusion layer 120, and chromate treatment may be further performed thereon. In this case, anticorrosive characteristics of the surface of the protrusion layer 120 may be further improved.

In one embodiment, treatment using a silane coupling agent may be further performed on the surface of the protrusion layer 120. For example, a composition in which a silane coupling agent is diluted may be applied to the protrusion layer 120 or the protrusion coating layer 140, followed by drying the same, to further form a silane coupling agent layer. Examples of the silane coupling agent may include: epoxy silane coupling agents such as 4-glycidylbutyltrimethoxysilane, 3-glycidoxypropyltrimethoxysilane, etc.; amino silane coupling agents such as 3-aminopropyltriethoxysilane, N-2(aminoethyl)3-aminopropyltrimethoxysilane, N-3-(4-(3-aminopropoxy)butoxy)propyl-3-aminopropyltrimethoxysilane, N-phenyl-3-aminopropyltrimethoxysilane, etc.; mercapto silane coupling agents such as 3-mercaptopropyltrimethoxysilane, olefinic silane coupling agents such as vinyltrimethoxysilane, vinylphenyltrimethoxysilane, etc.; acrylic silane coupling agents such as 3-methacryloxypropyltrimethoxysilane and the like.

A surface-treated layer 130 may be further formed on the upper surface of the copper foil layer 110. The surface-treated layer 130 may be formed through the material and process substantially the same as or similar to those of the protrusion coating layer 140. For example, the surface-treated layer 130 may be formed through plating or anticorrosive treatment using, for example, nickel (Ni), zinc (Zn) and/or chromium (Cr).

As shown in FIG. 2, a carrier foil 90 may be attached to the upper surface of the copper foil layer 110. The carrier foil 90 may be bonded to the surface-treated copper foil 100 through a release layer 80. The carrier foil 90 may serve as a support member when bonding the surface-treated copper foil 100 with the insulation layer or a substrate. After attaching the surface-treated copper foil 100 through the release layer 80, the carrier foil 90 may be removed.

A copper foil having a sufficient thickness for facilitating process treatment of the surface-treated copper foil 100 may be used as the carrier foil 90. For example, the carrier foil 90 may have a thickness of 15 to 50 µm.

The release layer 80 may contain Cr, Ni, Co, Zn, Fe, Mo, Ti, W, P or an alloy thereof. An organic film such as a silane coupling agent or rubber may be formed on the release layer 80.

A carrier surface layer 70 may also be formed on an upper surface of the carrier foil 90. The carrier surface layer 70 may be formed through plating using, for example, nickel (Ni), zinc (Zn) and/or chromium (Cr) or anticorrosive treatment.

According to exemplary embodiments, there is provided a circuit board to which the above-described surface-treated copper foil 100 is applied.

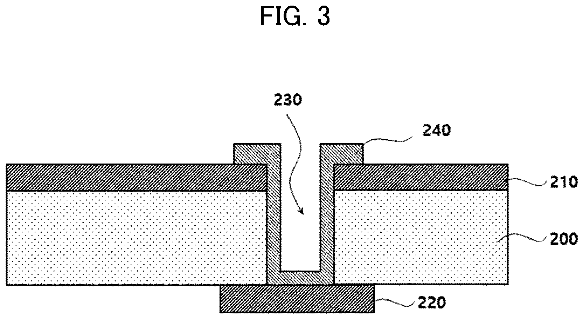

FIG. 3 is a schematic cross-sectional view illustrating a circuit board according to exemplary embodiments. For the convenience of description, detailed structures such as the protrusions and pores of the surface-treated copper foil 100 are not illustrated in FIG. 3.

Referring to FIG. 3, the circuit board may include a wiring layer formed on an insulation layer 200.

The insulation layer 200 includes an organic resin layer such as an epoxy resin, and may further include inorganic particles or inorganic fibers (e.g., glass fibers) impregnated into the resin layer. For example, the insulation layer 200 may be made from prepreg.

The wiring layer may include an upper wiring layer 210 and a lower wiring layer 220, which are formed on an upper surface and a lower surface of the insulation layer 200, respectively. At least one of the upper wiring layer 210 and the lower wiring layer 220 may be formed from the surface-treated copper foil 100 according to the above-described exemplary embodiments.

As described above, the surface-treated copper foil 100 includes the protrusions and the pores, and may be attached to the surface of the insulation layer 200 with high reliability and high adhesion.

The circuit board may further include a via structure 240 which passes through the insulation layer 200 to electrically connect the upper wiring layer 210 and the lower wiring layer 220 with each other. For example, a via hole 230 penetrating the upper wiring layer 210 and the insulation layer 200 may be formed. Thereafter, the via structure 240 may be formed by at least partially filling the via hole 230 through an electroless plating or electrolytic plating process.

Hereinafter, embodiments provided in the present application will be further described with reference to specific experimental examples. However, the following experimental examples only illustrate the present invention and are not intended to limit the appended claims, and those skilled in the art will obviously understand that various alterations and modifications are possible within the scope and spirit of the present invention. Such alterations and modifications are duly included in the appended claims.

### Example 1

### (1) Formation of copper foil layer

An untreated electrolytic copper foil having a surface roughness of 1.1 µm and a thickness of 40 µm was used as a carrier foil, and chrome electroplating was performed on the surface of the carrier foil to form a chrome plating layer (release layer) having a thickness of 0.006 µm. Subsequently, electrolytic plating was performed thereon using a copper sulfate solution represented by Electrolyte composition below as an electrolyte under conditions of a current density of 35 A/dm² and an electrolyte temperature of 45□ to form a copper foil layer having a thickness of 6 µm.

### (Electrolyte composition)

Copper sulfate (CuSO₄ • 5H₂O): 250 to 350 g/L
Sulfuric acid (H₂SO₄): 80 to 120 g/L
Sodium 3-Mercapto-1-propanesulfonate: 0.5 to 5 ppm
Cellulose acetate butyrate (molecular weight: 12,000 or less, Sigma Aldrich):
   1 to 10 ppm
   1,6-Anhydro-β-D-glucose: 1 to 10 ppm
   Cl: 10 to 50 ppm

### (2-1) Roughened particle (protrusion) electrodeposition: preliminary electrolytic plating

Anode electrolytic treatment was performed on a ultra-thin copper foil by direct current under the following conditions, such that copper finely roughened particles (protrusion growth nuclei) were electrodeposited.
(a) Electrolyte composition
   Copper sulfate (CuSO₄ • 5H₂O): 80 to 140 g/L
   Sulfuric acid (H₂SO₄): 110 to 160 g/L
   5-Mercapto-1H-1,2,3-triazole Sodium Salt: 0.1 to 4 g/L
   Ferrous sulfate (FeSO₄ • 7H₂O): 1 to 15 g/L
   1,6-Anhydro-β-D-glucose: 1 to 10 ppm
   4-Amino-3-hydrazino-5-mercapto-1,2,4-triazole: 1 to 10 ppm
(b) Electrolytic treatment conditions
   i) Temperature of electrolyte: 35 °C
   ii) Current density: 36A/dm²
   iii) Treatment time: 10 seconds

### (2-2) Capsule plating: Plating for forming protrusions

Capsule plating was performed under the following conditions to form a protrusion layer.
(a) Electrolyte composition
   Copper sulfate (CuSO₄ • 5H₂O) 200 to 300 g/L
   Sulfuric acid (H₂SO₄) 90 to 130 g/L
(b) Electrolytic treatment conditions
   i) Electrolyte temperature: 60°C
   ii) Current density: 15 A/dm²
   iii) Treatment time: 8 seconds

### (3) Surface treatment

Nickel-phosphorus plating (Ni = 0.1 mg/dm²) and zinc plating (Zn = 0.1 mg/dm²) were performed on the surface of the copper foil layer having the protrusion layer formed thereon. Thereafter, chromate treatment (Cr = 0.06 mg/dm²) was performed thereon, followed by performing treatment using an epoxy silane coupling agent (Si = 0.004 mg/dm²), to form a surface-treated layer.

### Example 2

Plating for forming roughened particles (protrusions) was performed by changing the copper foil layer electrolyte composition as follows under the following conditions.
(1) Formation of copper foil layer
   Copper sulfate (CuSO₄ • 5H₂O) 250 to 350 g/L
   Sulfuric acid (H₂SO₄) 80 to 120 g/L
   Sodium 3-Mercapto-1-propanesulfonate: 0.5 to 5 ppm
(2) Formation of roughened particle electrodeposition (protrusion layer)
   (a) Electrolyte composition
      Copper sulfate (CuSO₄ • 5H₂O) 80 to 140 g/L
      Sulfuric acid (H₂SO₄) 110 to 160 g/L
      Sodium molybdate (Na₂Mo₄ • 2H₂O) 0.05 to 3 g/L
      Ferrous sulfate (FeSO₄ • 7H₂O) 1 to 15 g/L
   (b) Temperature of electrolyte: 40°C
   (c) Current density: 45 A/dm²
   (d) Treatment time: 6 seconds

### Comparative Example

A commercially available copper foil product (copper foil layer thickness: 6 µm) having no pores formed therein and a roughening-treated surface (roughness: 2.5 µm) was purchased and prepared.

Diameters, the number of pores and intervals therebetween were measured from SEM images on cross-sections of the copper foils according to Example 1 and Example 2. Measurement results are shown in Table 1 below.

**[TABLE 1]**

| | The number of pores having a diameter of 0.05 µm or more (Number/µm) | The number of pores having a diameter of 0.01 to 0.05 µm (Number/µm) | Average interval between pores (µm) |
|---|---|---|---|
| Example 1 | 0 | 4 | 0.2 |
| Example 2 | 3 | 10 | 0.1 |

### Measurement of peeling force

After cutting the surface-treated copper foils of the examples and comparative examples into a size of 250 mm long and 250 mm wide, respectively, polyimide sheets (manufactured by Ube Kosan Co., Ltd.) UPILEX-VT) having a thickness of 50 µm were loaded on the protrusion layers or the roughened surfaces of the surface-treated copper foils, and the entire laminate was disposed between two smooth stainless steel plates. Then, thermal compression was performed thereon with a vacuum press of 20 torr at a temperature of 330□ and a pressure of 2 kg/cm² for 10 minutes, and then thermal compression was performed again thereon at a temperature of 330□ and a pressure of 50 kg/cm² for 5 minutes.

A peeling strength of the surface-treated copper foil-polyimide film laminate (copper clad laminate) prepared as described above was measured according to the standard of JIS C6471 at 180 □.

Measurement results are shown in Table 2 below.

**[TABLE 2]**

| Pores | Peeling strength (KN/m) |
|---|---|
| Example 1 | 1.04 |
| Example 2 | 0.78 |
| Comparative Example | 0.71 |

Referring to Table 2, it can be confirmed that the peeling strength was improved in the copper foils of the examples. Further, in Example 1 in which pores having a diameter range of 0.01 to 0.05 µm are formed at an interval of a predetermined range, the peeling strength was more increased.

## Claims

1. A surface-treated copper foil comprising:
a copper foil layer; and
a protrusion layer formed on one surface of the copper foil layer,
wherein the surface-treated copper foil comprises pores formed inside the protrusion layer or around a boundary between the copper foil layer and the protrusion layer.

2. The surface-treated copper foil according to claim 1, wherein the pores comprise first pores arranged along a boundary line between the copper foil layer and the protrusion layer.

3. The surface-treated copper foil according to claim 2, wherein the first pores have an average diameter of 0.01 to 0.05 µm.

4. The surface-treated copper foil according to claim 3, wherein an average interval between the adjacent first pores is 0.15 to 0.25 µm.

5. The surface-treated copper foil according to claim 2, wherein the first pores are distributed in a height region within 1/3 from the lowest point of the protrusion layer based on a sum of thicknesses of the copper foil layer and the protrusion layer.

6. The surface-treated copper foil according to claim 2, wherein the pores further include second pores formed inside the protrusion layer.

7. The surface-treated copper foil according to claim 6, wherein the number of the second pores is smaller than the number of the first pores.

8. The surface-treated copper foil according to claim 6, wherein the protrusion layer includes a plurality of protrusions, and a ratio of a cross-sectional area of the second pores to a cross-sectional area of one of the protrusions is 0.001 to 20%.

9. The surface-treated copper foil according to claim 6, wherein the protrusion layer includes a plurality of protrusions, and a ratio of a cross-sectional area of the second pores to a cross-sectional area of one of the protrusions is 0.001 to 5%.

10. A circuit board comprising:
an insulation layer; and
a wiring layer formed on a surface of the insulation layer, the wiring layer including a copper foil layer and a protrusion layer formed on one surface of the copper foil layer,
wherein the wiring layer includes pores formed inside the protrusion layer or around a boundary between the copper foil layer and the protrusion layer.
